Europäisches Patentamt

European Patent Office

Office européen des brevets

(11) Veröffentlichungsnummer: **0 004 870**
B1

(12) **EUROPÄISCHE PATENTSCHRIFT**

(45) Veröffentlichungstag der Patentschrift: **03.02.82**

(21) Anmeldenummer: **79100803.0**

(22) Anmeldetag: **15.03.79**

(51) Int. Cl.³: **H 03 H 15/02, H 01 L 27/10**

(54) Transversalfilter mit Paralleleingängen.

(30) Priorität: **31.03.78 DE 2814053**

(43) Veröffentlichungstag der Anmeldung:
**31.10.79 Patentblatt 79/22**

(45) Bekanntmachung des Hinweises auf die Patenterteilung:
**03.02.82 Patentblatt 82/5**

(84) Benannte Vertragsstaaten:
**BE FR GB IT NL**

(56) Entgegenhaltungen:
FR - A - 2 285 680
FR - A - 2 375 776
NL - A - 77 10541
US - A - 4 035 628
US - A - 4 080 581
US - A - 4 120 035

3rd International Conference on Charge Coupled
Devices, September 1976, University of
Edinburgh, Edinburgh, GB
J. E. Dilley: "A microcomputer controlled
adaptive CCD transversal filter", Seiten 269—
276

(73) Patentinhaber: **SIEMENS AKTIENGESELLSCHAFT
Berlin und München
Postfach 22 02 61
D-8000 München 22 (DE)**

(72) Erfinder: **Knauer, Karl, Dipl.-Ing.
Am Dachsberg 13
D-8011 Kirchseeon (DE)**
Erfinder: **Pfleiderer, Hans-Jörg, Dr.
Franz-Krinninger-Weg 23
D-8011 Zorneding (DE)**

(56) Entgegenhaltungen:
NHK Laboratories Note, Serie Nr. 226, Mai
1978, Tokyo, JP,
S. Ohnishi: "Application of charge-coupled
device for cancellation of TV ghost signals",
Seiten 1, 3—9

Siemens Forschungs-und Entwicklungsberichte;
Band 7 Nr. 3, Mai-Juni 1978, Berlin, DE,
K. Knauer: CCD transversal filters with parallel-
in/serial-out configuration", Seiten 138—142

Courier Press, Leamington Spa, England.

## Transversalfilter mit Paralleleingängen

Die Erfindung bezieht sich auf ein Transversalfilter, bei dem die Stufen eines auf einem dotierten Halbleitersubstrat integrierten, analogen CTD-Schieberegisters mit Paralleleingängen und diesen zugeordneten Bewertungsschaltungen versehen sind, bei dem die Bewertungsschaltungen jeweils ein entgegengesetzt zu dem Substrat dotiertes Gebiet, ein erstes und zweites Eingangsgate und ein Transfergate aufweisen, wobei das Transfergate unmittelbar neben dem Transferkanal des CTD-Schieberegisters angeordnet ist, das eine Eingangsgate mit einem Eingangssignal, das andere Eingangsgate mit einer konstanten Gleichspannung, das entgegengesetzt dotierte Gebiet mit einer ersten und das Transfergate mit einer zweiten Taktspannung beschaltet sind, und bei dem das Ausgangssignal an einem Ausgang des CTD-Schieberegisters abgreifbar ist.

Ein derartiges Transversalfilter ist aus der Zeitschrift "Electronics Letters", Bd. 13, Nr. 5 vom 3. März 1977, Seiten 126 und 127, bekannt. Die Größe der einzelnen Koeffizienten, mit denen das Eingangssignal an jedem Paralleleingang individuell bewertet wird, ist dabei durch die Kapazität des zweiten Eingangsgate gegeben. Transversalfilter dieser Gattung bilden auch den Gegenstand der deutschen Patentanmeldung gemäß der DE—A—26 43 704.

Aus den "Proceedings of the 8th Conference (1976 International) on Solid State Devices, Tokyo, 1976", abgedruckt im "Japanese Journal of Applied Physics", Vol. 16 (1977) Supplement 16-1, Seiten 387—390 ist ein solches Transversalfilter bekannt, bei dem ein CCD-Schieberegister mehrere durch Trenndiffusionen gegeneinander isolierte Transferkanäle aufweist, die den Paralleleingängen jeweils individuell zugeordnet sind. Hierbei besteht das in den Bewertungsschaltungen jeweils vorgesehene Transfergate aus der ersten Verschiebeelektrode des zugehörigen Transferkanals. Die Transferkanäle werden in einer gemeinsamen Ausgangsstufe, in deren Bereich die genannten Trenndiffusionen weggelassen sind, zusammengeführt. Dort erfolgt eine Summierung der über die Kanäle getrennt übertragenen und mit unterschiedlichen Verzögerungen eintreffenden Signalanteile zu einem Ausgangssignal. Die Bewertungskoeffizienten, mit denen das den Paralleleingängen zugeführte Signal belegt wird, sind durch die Gateflächen in den einzelnen Bewertungsschaltungen gegeben. Nachteilig ist hierbei, daß die erforderliche Halbleiterfläche mit der Anzahl der Paralleleingänge stark ansteigt.

Aus den oben genannten "Proceedings", abgedruckt in dem "Japanese Journal of Applied Physics", Vol. 16 (1977), Supplement 16-1, Seiten 391—396, ist ein weiteres Transversalfilter bekannt, das sich von der eingangs erwähnten Gattung durch eine andere Ausbildung der Bewertungsschaltungen und der Paralleleingänge unterscheidet. Jede einzelne Bewertungsschaltung enthält hier zwei in Series geschaltete MOS-Feldeffekttransistoren und eine Widerstandsdiffusion, während jeder Paralleleingang eine mit einer Eingangsdiffusion versehene Stufe eines Vier-Phasen-CCD-Schieberegisters aufweist. Dabei ist die Eingangsdiffusion mit einem Anschluß des Widerstandes verbunden und die letzte Verschiebeelektrode zu einer Verschiebeelektrode eines die Summierung der Signalanteile Vornehmenden CCD-Schieberegisters benachbart angeordnet. Das Gate des einen MOS-Feldeffekttransistors jeder Bewertungsschaltung wird mit dem Eingangssignal belegt, das Gate des anderen jeweils mit einer Gleichspannung, die durch ihre Größe den durch die Transistoren fließenden Strom und damit den jeweiligen Bewertungskoeffizienten bestimmt. Damit sind die Übertragungseigenschaften des Transversalfilters elektrisch einstellbar. Nachteilig ist jedoch, daß der Strom nur in einem kleinen Änderungsbereich linear von der ganannten Gleichspannung abhängt.

Es wurde bereits vorgeschlagen, vergl. die ältere deutsche Patentanmeldung gemäß der DE—A—26 44 284, bei einem Transversalfilter der eingangs genannten Art in den einzelnen Bewertungsschaltungen zur Realisierung eines Bewertungskoeffizienten jeweils zweimal hintereinander Ladungsmengen zu bilden und in die Zugehörigen Stufen des CTD-Schieberegisters einzugeben, um die Bewertungsschaltungen flächensparend ausbilden zu können.

Der vorliegenden Erfindung liegt die Aufgabe Zugrunde, ein Transversalfilter der eingangs genannten Art Vorzusehen, dessen Bewertungskoeffizienten mit großer Genauigkeit elektrisch einstellbar sind, wobei ein großer relativer Einstellbereich überstrichen werden soll. Das wird gemäß der Erfindung durch die im kennzeichnenden Teil des Patentanspruches 1 angeführten Maßnahmen erreicht.

Der mit der Erfindung erzielte Vorteil besteht insbesondere darin, daß durch die gespeicherten digitalen Signale in sehr übersichtlicher Weise Festgelegt ist, wie oft aus einer Bewertungsschaltung eine durch deren Fläche gegebene Ladungsmenge in die zugehörige Stufe des CTD-Schieberegisters eingegeben wird, wobei sich aus der Anzahl der jeweils eingegebenen Ladungsmengen die den Bewertungsschaltungen zugeordneten Bewertungskoeffizienten ergeben. Da das Eingeben der Ladungsmengen mit einer wesentlich höheren Frequenz erfolgen kann als das Takten des CTD-Schieberegisters, ist es möglich, für die Bewertungskoeffizienten große relative Einstellbereiche vorzusehen, die beispielsweise Größenverhältnisse von 1:1000 oder mehr einschließen. Zwischen der die Einstellung eines Bewertungskoeffizienten kontrollierenden Größe, das heißt dem eingespeicherten digitalen Signal, und dem eingestellten Bewertungskoeffizienten besteht dabei eine lineare Abhängigkeit. Die einfache und innerhalb weiter Grenzen gegebene Einstellbarkeit der Bewertungskoeffizienten ermöglicht eine sehr vielseitige Anwendung des erfindungsgemäßen Transversalfilters.

Die Erfindung wird nachfolgend anhand einiger in der Zeichnung dargestellter, bevorzugter Ausführungsbeispiele näher erläutert.

Dabei zeigt:

Fig. 1 eine Prinzipdarstellung des eingangs erwähnten, bekannten Transversalfilters mit einem CCD-Schieberegister mit Paralleleingängen und einem Serienausgang,

Fig. 2 einen Querschnitt durch eine Teilschaltung von Fig. 1,

Fig. 3 ein Zeitdiagramm der für ein Transversalfilter nach den Figuren 1 bis 6 erforderlichen Betriebsspannungen,

Fig. 4 ein erstes Ausführungsbeispiel der Erfindung,

Fig. 5 ein zweites Ausführungsbeispiel und

Fig. 6 ein weiteres Ausführungsbeispiel der Erfindung.

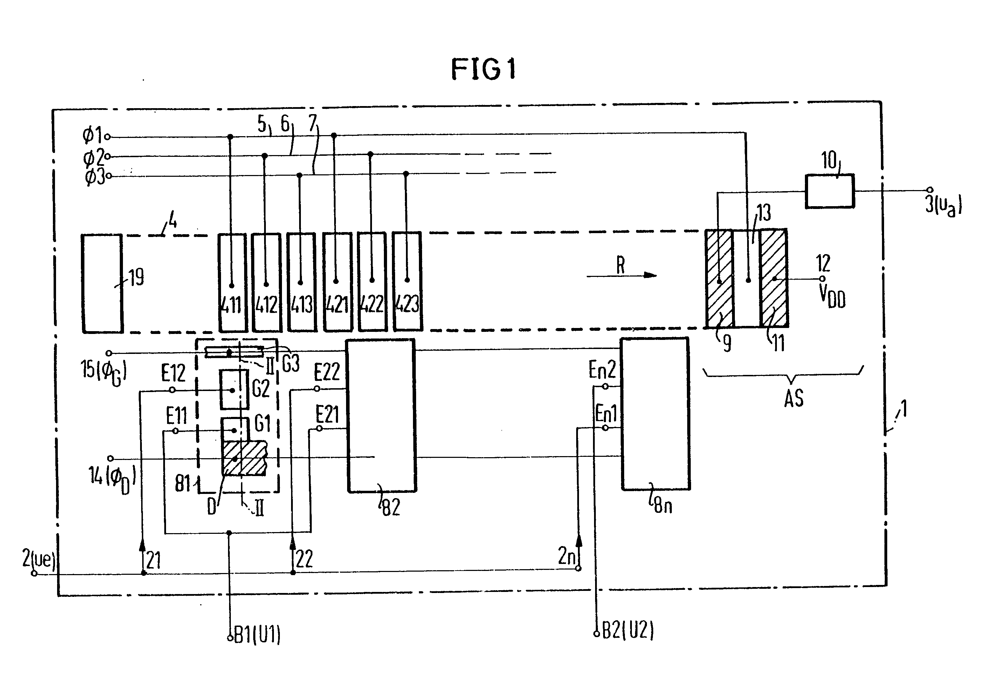

Das in Figur 1 schematisch dargestellte Transversalfilter ist als eine auf einem dotierten Halbleitersubstrat 1, z.B. p-leitendem Silizium, monolithisch integrierte Halbleiterschaltung ausgebildet. Einem Anschluß 2 wird ein analoges Eingangssignal $u_e$ zugeführt, während am Ausgang 3 ein analoges Ausgangssignal $u_a$ abgreifbar ist, dessen zeitlicher Verlauf dem des Signals $u_e$ entspricht, nachdem dieses ein Frequenzfilter mit einer bestimmten Frequenzcharakteristik durchlaufen hat. Die Frequenzcharakteristik kann beispielsweise die eines Tiefpasses sein. Ein mit 4 bezeichnetes Schieberegister ist als eine ladungsgekoppelte Anordnung (CCD) ausgebildet und arbeitet im 3-Phasen-Betrieb, Sie weist eine Reihe von Elektroden 411, 412, 413, 422, 423 usw. auf, die über einer das Substrat 1 abdeckenden, dünnen Isolierschicht, z.B. einer Gateoxidschicht aus $SiO_2$, dicht nebeneinanderliegend in Verschieberichtung R plaziert sind.

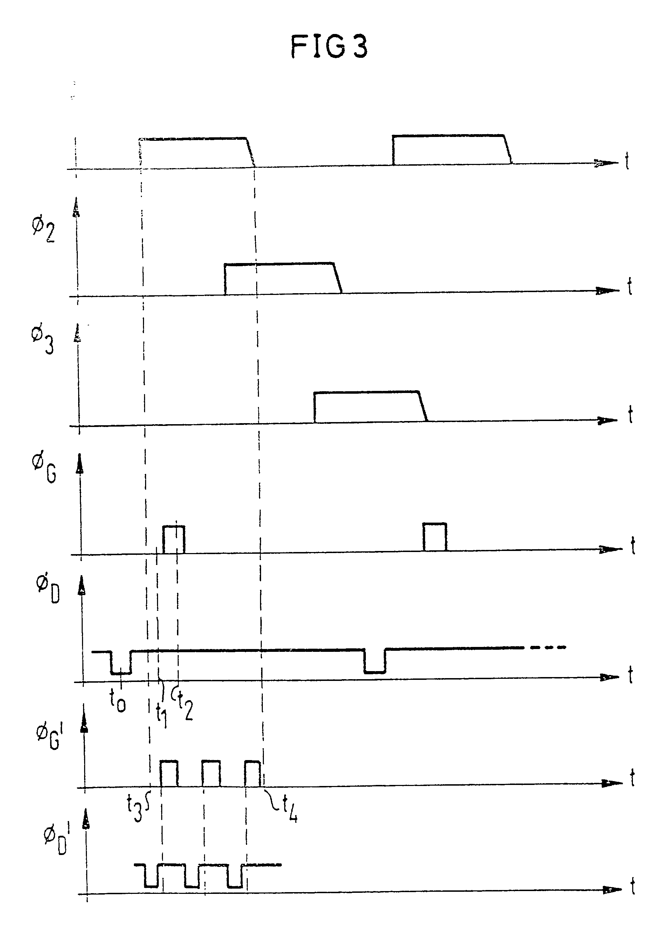

Jeweils drei nebeneinander liegende Elektroden, z.B. 411, 412 und 413 oder 421, 422 und 423, gehören zu einer Schieberegisterstufe, wobei die ersten Elektroden 411, 421 usw. sämtlicher Stufen an eine Leitung 5 angeschlossen und über diese mit einer Verschiebetaktspannung $\phi_1$ beschaltet sind, während die zweiten Elektroden 412, 422 usw. an einer gemeinsamen, mit einer Verschiebetaktspannung $\phi_2$ beschalteten Leitung 6 und die dritten Elektroden 413, 423 usw. an einer mit ener Verschiebetaktspannung $\phi_3$ beschalteten Leitung 7 liegen. Bei einem zeitlichen Verlauf der Spannungen $\phi_1$ bis $\phi_3$ gemäß Figur 3 ergeben sich unterhalb jeder dritten Elektrode lokale Maxima des Oberflächenpotentials $\phi_s$ im Halbleitersubstrat 1, sogenannte Potentialtöpfe, die im Takte der Spannungen $\phi_1$ bis $\phi_3$ in Richtung R schrittweise von Stufe zu Stufe verschoben werden. Injiziert man nun in diese jeweils von Raumladungszonen umgebenen Potentialtöpfe elektrische Ladungen, die eine Polarität aufweisen, die der der Minoritätsladungsträger des Substrates 1 entspricht, so werden diese mit den Potentialtöpfen verschoben und können nach dem Durchlaufen des gesamten Schieberegisters 4 in dessen Ausgangsstufe AS zeitverzögert ausgelesen werden. Bei der in Figur 1 dargestellten Ausführungsform des Schieberegisters 4 enthält die Ausgangsstufe AS ein zeitweilig von äußeren Potentialen freigeschaltetes Diffusionsgebiet 9 (floating diffusion output). Dieses ist über einen Ausgangsverstärker 10 mit dem Ausgang 3 leitend verbunden. Das Gebiet 9 stellt zusammen mit einem zweiten Diffusionsgebiet 11, das über einen Anschluß 12 mit einer Drainspannung $V_{DD}$ beschaltet ist, und einer Gateelektrode 13, die über die Leitung 5 an der Verschiebetaktspannung $\phi_1$ liegt, einen Feldeffekttransistor dar, der beim Auftreten der einzelnen Spannungsimpulse von $\phi_1$ das Gebiet 9 intermittierend auf ein Referenzpotential setzt.

Der Eingang 2 des Transversalfilters ist mit einer Reihe von Paralleleingängen 21, 22, 2n verbunden, die jeweils einzelnen Stufen des Schieberegisters 4 zugeordnet sind. Jeder dieser Paralleleingänge ist mit einer Bewertungsschaltung 81, 82, 8n versehen. Diese weisen jeweils ein entgegengesetzt zum Substrat 1 dotiertes Gebiet D, ein erstes Eingangsgate G1, ein zweites Eingangsgate G2 und ein Transfergate G3 auf, wobei die Gebiete D aller Bewertungsschaltungen 81 bis 8n zusammenhängend ausgebildet und mit einem Anschluß 14 verbunden sind, währen die Transfergateelektroden G3 aller Bewertungsschaltungen ebenfalls zusammenhängend ausgebildet und mit einem Anschluß 15 versehen sind. Das erste Eingangsgate G1 der Bewertungsschaltung 81 ist mit einem Anschluß E11 versehen, G2 mit einem Anschluß E12. Die entsprechenden Anschlüsse von 82 sind mit E21 und E22 bezeichnet, die der Bewertungsschaltung 8n mit En1 und En2. In Figur 1 sind die Anschlüsse E12, E22 und En1 jeweils mit den Paralleleingänges 21, 22 und 2n verbunden, während die Anschlüsse E11 und E21 an einen gemeinsamen Anschluß B1 und der Anschluß En2 an einen Anschluß B2 geführt sind.

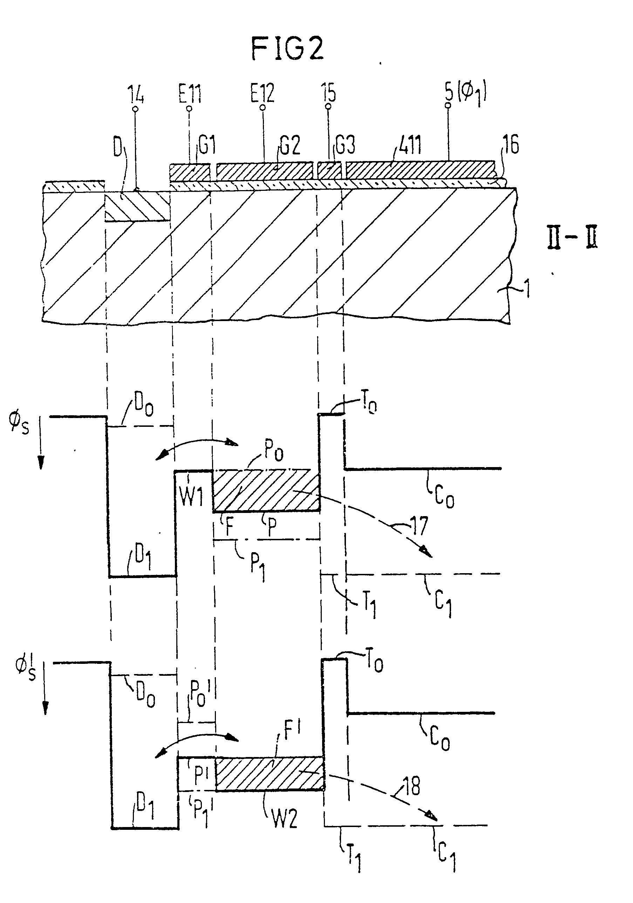

In Figur 2 ist die Bewertungsschaltung 81 längs der Linie II—II geschnitten dargestellt. Dabei sind die bereits in Figur 1 gezeigten Teile mit denselben Bezugszeichen versehen. Die dünne Isolierschicht, auf der die Teile G1, G2, G3 und die Elektrode 411 des CTD-Schieberegisters plaziert sind, ist mit 16 bezeichnet. Die Bewertungsschaltung 81 ist für einen positiven Bewertungskoeffizienten eingerichtet. Dabei wird dem Anschluß E11 des ersten Eingangsgate G1 über B1 eine konstante Gleichspannung U1 zugeführt, die höchstens so groß ist wie das kleinste zu bewertende Eingangssignal $u_e$, so daß sich für das Oberflächenpotential $\phi_s$ unterhalb von G1 eine feste Potentialschwelle W1 ergibt. Dem Anschluß E12 wird über den Paralleleingang 21 das Eingangssignal $u_e$ zugeführt, wobei sich unterhalb von G2 Potentialwerte P zwischen $P_1$ (für das maximale Signal $u_e$) und $P_0$ (für das minimale Signal $u_e$) ergeben.

Unter dem Einfluß der in Figur 3 dargestellten Taktspannungen $\phi_G$ und $\phi_D$, die jeweils den Anschlüssen 15 und 14 zugeführt werden, ergeben sich Potentialwerte $D_1$ bzw. $D_0$ und $T_1$ bzw. $T_0$ innerhalb des dotierten Gebietes D und unterhalb des Transfergate G3 gemäß Figur 2. Zum Zeitpunkt $t_0$ (Fig. 3) besteht ein Potentialverlauf $D_0$, $W_1$, P, $T_0$ und $C_0$, wobei der Potentialwert P durch die Größe des auftretenden Eingangssignales $u_e$ gegeben ist. Dabei wird der unterhalb von G2 gebildete Potentialtopf mit Ladungsträgern überschwemmt. Zum Zeitpunkt $t_1$ ist $D_0$ in $D_1$ übergegangen, wobei die Ladungsträger wieder soweit aus dem Bereich unterhalb von G1 und G2 in das Gebiet D zurückfließen daß der unterhalb von G2 gebildete Potentialtopf nur noch bis zu dem durch $W_1$ gegebenen Rand angefüllt bleibt, was in Figur 2 durch die schraffierte Fläche F angedeutet ist. Ist dann $T_0$ in $T_1$ übergegangen (Zeitpunkt $t_2$) so wird die durch F angedeutete Ladungsmenge entsprechend dem Pfeil 17 unter die Elektrode 411 verschoben, da diese gleichzeitig mit einer relativ hohen Verschiebetaktspannung $\phi_1$ belegt ist, die einen Potentialwert $C_1$ ergibt. Wesentlich ist hierbei, daß bei einer Ausbildung der Schaltung 81 für einen positiven Bewertungskoeffizienten beim Auftreten des minimalen Eingangssignals $u_e$ wegen $P=P_0$ keine Ladungsmenge eingelesen wird, beim Auftreten des maximalen Eingangssignals $u_e$ wegen $P=P_1$ die maximale Ladungsmenge, die durch die zwischen den Werten $P_0$ und $P_1$ liegende Fläche dargestellt werden kann. Der Einlesevorgang wiederholt sich mit der Frequenz der Verschiebetaktspannung $\phi_1$.

Ist eine Bewertungsschaltung, z.B. die Schaltung 8n in Figur 1, für einen negativen Bewertungskoeffizienten eingerichtet, so wird ihrem ersten Eingangsgate über den Anschluß En1 von einem Paralleleingang 2n das Eingangssignal $u_e$ zugeführt, während ihr zweites Eingangsgate über einen Anschluß En2 und einen Anschluß B2 nunmehr mit einer konstanten Gleichspannung U2 belegt ist, die wenigstens so groß ist wie das maximale zu bewertende Eingangssignal $u_e$ und unterhalb von G2 einen festen Potentialwert W2 ergibt. Unterhalb von G1 ergeben sich dann Potentialwerte $P_1'$ für das maximale Eingangssignal und $P_0'$ für das minimale Eingangssignal $u_e$. Das Anfüllen des Potentialtopfes unterhalb von G2 ist dabei nur bis zu dem durch das zum Zeitpunkt t1 anliegende Eingangssignal $u_e$ bestimmten Rand P' möglich, was in Figur 2 durch die Fläche F' gekennzeichnet ist. Nach dem Übergang von $T_0$ auf $T_1$ und von $C_0$ auf $C_1$ (Zeitpunkt t2) wird die Ladungsmenge F' wieder unter eine Elektrode des CCD-Schieberegisters 4 verschoben (Pfeil 18). Wesentlich ist, daß bei einem negativen Bewertungskoeffizienten beim Auftreten des minimalen Eingangssignals $u_e$ wegen $P'=P_0'$ die maximale Ladungsmenge eingegeben wird, was in Figur 2 durch eine Fläche unterhalb von G2 und zwischen den Potentialwerten $P_0'$ und $P_1'$ verdeutlicht wird, während für das maximale Eingangssignal $u_e$ wegen $P'=P_1'$ keine Ladungsmenge eingelesen wird. Auch dieser Einlesevorgang wiederholt sich mit der Frequenz der Verschiebetaktspannung $\phi_1$.

Somit finden in dem Schieberegister 4 unter den jeweils ersten Elektroden 411, 421 usw. einer Stufe jeweils beim Auftreten der Verschiebetaktspannungen $\phi_1$ Summierungsvorgänge statt, bei denen zu den jeweils innerhalb des Schieberegisters 4 verschobenen Ladungsmengen die über die zugehörigen Paralleleingänge eingegebenen Ladungsmengen F bzw. F' addiert werden. Die auf diese Weise durch mehrfache Summierungsvorgänge angewachsenen Ladungsmengen, die schließlich in der letzten Stufe des Schieberegisters 4 nacheinander ankommen, bewirken dann beim Eindringen in das Diffusionsgebiet 9, das zuvor auf Referenzpotential gebracht wurde, jeweils Potentialverschiebungen, die über den Verstärker 10 ausgewertet und zu dem befilterten Ausgangssignal $u_a$ zusammengesetzt werden.

Man kann durch eine mit 19 angedeutete, an sich bekannte Eingangsstufe des Schieberegisters 4, die beispielsweise in dem Buch von Sequin und Tompsett "Charge Transfer Devices", Academic Press, New York, 1975 auf den Seiten 48 bis 50, insbesondere Figur 3.12(d), beschrieben ist, zu den über das Schieberegister verschobenen Ladungsmengen eine konstante Grundladung hinzufügen, die in der Literatur auch als "fat zero" bezeichnet wird. Hierbei besteht das dieser Eingangsstufe zugeführte Signal aus einer Gleichspannung.

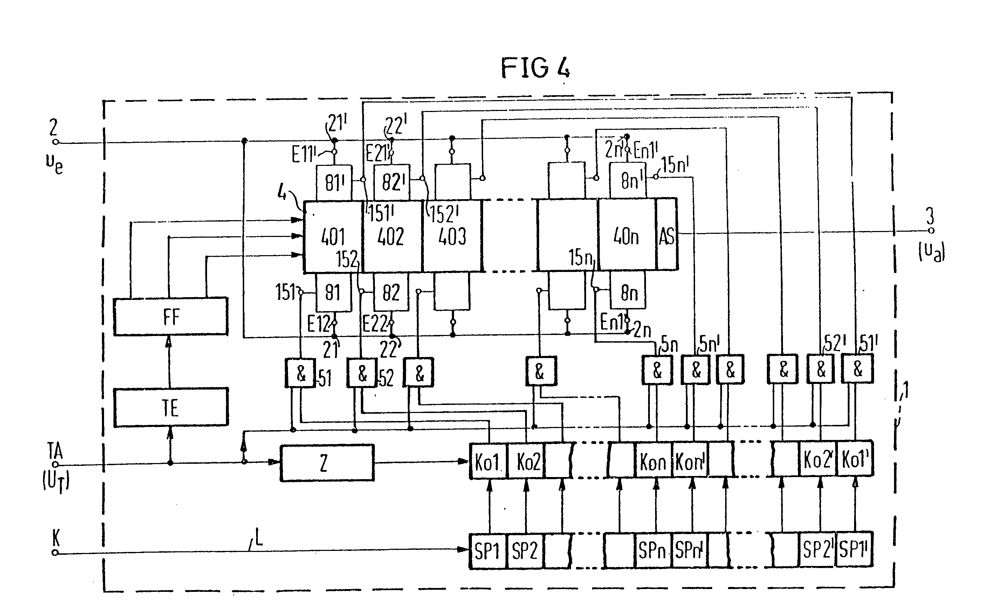

In Figur 4 ist ein nach der Erfindung ausgebildetes Transversalfilter schematisch dargestellt. Dabei sind die bereits anhand der Figuren 1 bis 3 beschriebenen Teile mit den gleichen Bezugszeichen versehen. Das Schieberegister 4 kann jedoch ganz allgemein aus einer der unter dem Begriff Ladungsverschiebeanordnungen (CTD, Charge Transfer Device), zusammengefaßten, an sich bekannten Anordnungen bestehen, wie sie beispielsweise in dem Buch von Sequin und Tompsett "Charge Transfer Devices" Academic Press, New York, 1975, Seiten 1 bis 18 beschrieben sind. Eine solche Ladungsverschiebeanordnung kann dabei entsprechend ihrem Aufbau im 2-Phasen-, 3-Phasen- oder 4-Phasen-Betrieb arbeiten. Die einzelnen Stufen des Schieberegisters sind in Figur 4 als Blöcke dargestellt und mit 401, 402 bis 40n bezeichnet. Die Ausgangsstufe ist wieder mit AS bezeichnet, während die in Figur 1 mit 19 angedeutete Eingangsstufe wegen der besseren Übersicht weggelassen ist. Das über den Anschluß 2 zugeführte Eingangssignal $u_e$ liegt in an den Paralleleingängen 21, 22 bis 2n des Schieberegisters 4 und weiter an den Anschlüssen E12 und E22 der Bewertungsschaltungen 81 und 82 sowie an den Anschluß En1 der Bewertungsschaltungen 8n. Damit ist $u_e$ jeweils an das zweite Eingangsgate G2 der Schaltungen 81 und 82 geführt, während jeweils das erste Eingangsgate G1 dieser Schaltungen mit einer konstanten Gleichspannung U1 beschaltet sind, die höchstens so groß ist wie das kleinste Signal $u_e$. Bei der Bewertungsschaltung 8n ist $u_e$ an das erste Eingangsgate G1 beführt, während das zweite Eingangsgate G2 an einer konstanten Gleichspannung U2 liegt, die wenigstens so groß ist wie das größte Signal $u_e$. Hieraus ergibt sich, daß die Bewertungsschaltungen 81 und 82 für einen positiven Bewertungskoeffizienten eingerichtet sind, die Schaltung 8n dagegen für einen negativen.

Die Bewertungsschaltungen 81, 82 ... 8n sind mit Anschlüssen 151, 152 ... 15n versehen, denen die Taktspannungen für die einzelnen Transfergateelektroden G3 jeweils getrennt zugeführt werden. Dabei sind diese Taktspannungen von einer über einen Anschluß TA zugeführten Taktspannung $U_T$ jeweils über eine Reihe von aus UND-Gattern (&) gebildeten Torschaltungen 51, 52 bis 5n abgeleitet, deren erste Eingänge jeweils mit TA und deren Ausgänge mit den Anschlüssen 151, 152 bis 15n verbunden sind. Ihre zweiten Eingänge sind mit den Ausgängen von Komparatoren Ko1, Ko2 ... Kon beschaltet. Die ersten Eingänge aller Komparatoren Ko1 bis Kon liegen ferner am Ausgang eines Zählers Z, dessen Eingang mit dem Anschluß TA verbunden ist. Die zweiten Eingänge der Komparatoren sind mit den Ausgängen einer Reihe von digitalen Speichern SP1 bis SPn beschaltet, deren Eingabeleitungen L an einen Eingang K beführt sind.

Über K und die Eingabeleitung L des ersten digitalen Speichers SP1 wird nun in diesen zunächst eine Zahl in Form eines digitalen Signals eingegeben. Nach dem Rücksetzen des Zählers Z beginnt dieser die Impulse der bei TA anliegenden Taktspannung $U_T$ zu zählen. Der Komparator Ko1, der das in SP1 gespeicherte digitale Signal mit dem Ausgangssignal des Zählers Z vergleicht, liefert seinerseits nur solange ein das UND-Gatter 51 öffnendes Ausgangssignal, bis das Zählerausgangssignal bzw. der hierdurch ausgedrückte jeweilige Zählerstand das digitale Signal im Speicher SP1 erreicht oder übersteigt. Somit wird die Taktspannung $U_T$ dem Anschluß 151 der Bewertungsschaltung 81 vom Zeitpunkt $t_3$ des Rücksetzens des Zählers Z über das geöffnete UND-Gatter 51 solange als Taktspannung $\phi_G'$ (Fig. 3) zugeführt,

bis zum Zeitpunkt $t_4$ die in SP gespeicherte Zahl, im dargestellten Fall die Zahl 3, durch das Zählergebnis erreicht bzw. überschritten wird. Von dem Zeitpunkt $t_4$ an ist die UND-Schaltung 51 dann gesperrt. Für jeden Impuls von $\phi_G'$ wird zwischen den Zeitpunkten $t_3$ und $t_4$ beim Zuführen einer weiteren Taktspannung $\phi_D'$ an das entgegengesetzt dotierte Gebiet D von 81, die aus der Taktspannung $u_T$ über einen Inverter und ein Verzögerungsglied abgeleitet ist, eine bestimmte Ladungsmenge F (Fig. 2) unterhalb von G2 gebildet und entsprechend dem Pfeil 17 jeweils unter eine Verschiebeelektrode der Stufe 401 verschoben. Aus der Anzahl der im Intervall $t_3$ bis $t_4$ eingelesenen Ladungsmengen F ergibt sich dann der Betrag des dem Paralleleingang 21 zugeordneten Bewergungskoeffizienten, aus der Ansteuerung der Bewertungsschaltung 81 sein Vorzeichen. Durch Wahl der in SP1 gespeicherten Zahl, die auch mehrstellig sein kann, läßt sich somit genau festlegen, wie oft die Ladungsmenge F, die der jeweils anliegenden Amplitude von $u_e$ proportional ist, über den Eingang 21 in die Stufe 401 eingelesen wird. Die Folgefrequenz der Spannung $\phi_G'$ bzw. von $U_T$ muß dazu allerdings wesentlich höher liegen als die Folgefrequenz der Verschiebetaktspannung $\phi_1$. Durch einen Frequenzteiler TE wird die hohe Folgefrequenz von $U_T$ auf den für die Verschiebetaktspannung $\phi_1$ benötigten Wert herabgesetzt, wobei über eine Flip-Flop-Schaltung FF die Spannungen $\phi_1$ bis $\phi_3$ aus der geteilten Taktspannung $U_T$ abgeleitet werden.

Unabhängig voneinander können die weiteren digitalen Speicher SP2 bis SPn mit anderen digitalen Signalen belegt werden, wobei die eingegebenen Zahlenwerte in gleicher Weise eine Sperrung der Eingänge 152 bis 15n über die Komparatoren Ko2 bis Kon und die UND-Gatter 52 bis 5n vornehmen, sobald der Zählerstand die einzelnen Zahlen jeweils erreicht oder überschritten hat. Führt man beispielsweise den Paralleleingang 2n an den Eingang En2 der Bewertungsschaltung 8n und belegt En1 gleichzeitig mit der konstanten Gleichspannung U1 (Fig. 1), so ist auch für die Bewertungsschaltung 8n das Vorzeichen des Bewertungskoeffizienten positiv. Andererseits kann auch jede der Bewertungsschaltungen 81, 82 oder eine der weiteren durch Zuführung von $u_e$ an die jeweils erste Gateelektrode G1 und gleichzeitige Zuführung von U2 an die Gateelektrode G2 für negative Vorzeichen eingerichtet werden.

Nach einer Weiterbildung der Erfindung sind zusätzliche Paralleleingänge 21', 22', bis 2n' vorgesehen, die über zugeordnete Bewertungsschaltungen 81', 82' bis 8n' eine Ladungseingabe bei denselben Stufen des Schieberegisters 4 ermöglichen wie die Paralleleingänge 21, 22 bis 2n, aber jeweils auf der gegenüberliegenden Seite des Transferkanals von 4. Dabei müssen zwei einander gegenüberliegende Eingänge, z.B. 21 und 21', jeweils Bewertungsschaltungen, z.B. 81 und 81', aufweisen, die für dasselbe Vorzeichen eingerichtet sind. Die Bezugszeichen dieser zusätzlichen Bewertungsschaltung haben die gleiche Zahl wie die analogen Tiele der zuvor beschriebenen mit einem nachfolgenden Strich.

Eine andere Weiterbildung der Erfindung sieht vor, daß die Bewertungsschaltungen 81 bis 8n alle für einen positiven Bewertungskoeffizienten ausgerichtet sind, die Bewertungsschaltungen 81' bis 8n' dagegen alle für einen negativen. (An den Eingängen E11' und E21' des ersten Eingangsgates liegt dann, wie in Fig. 4 dargestellt, das Eingangssignal $u_e$.) In diesem Fall ist das Vorzeichen der einzelnen Bewertungskoeffizienten elektrisch programmierbar. Das geschieht dadurch, daß jeweils von zwei einander gegenüberliegenden Paralleleingängen, z.B. 21 und 21', die Bewertungsschaltung des einen, z.B. 81', an ihrem einen Taktspannungseingang, z.B. 151', ständig gesperrt ist, was man durch die Eingabe der Zahl "O" in den zugeordneten Speicher, z.B. SP1', erreicht. Damit ist von den beiden einander gegenüberliegenden Paralleleingängen nur einer wirksam und bestimmt durch seine Schaltungsgegebenheiten das Vorzeichen des der jeweiligen Schieberegisterstufe zugeordneten Bewertungskoeffizienten. In dieser Weise sind die Vorzeichen der Bewertungskoeffizienten für die einzelnen Stufen 401, 402 ... 40n unabhängig voneinander wählbar.

Nach einer bevorzugten Weiterbildung des Erfindungsgedankens bestehen die einzelnen digitalen Speicher SP1 bis SPn und gegebenenfalls SP1' bis SPn' aus den Stufen eines Statischen Schieberegisters, bei dem die gespeicherte Information nicht regeneriert werden muß. Dabei erfolgt die Eingabe aller au speichernden Zahlen in der Reihenfolge der Stufen SP1', SP2', nacheinander über den Eingang K und die Eingabeleitung L.

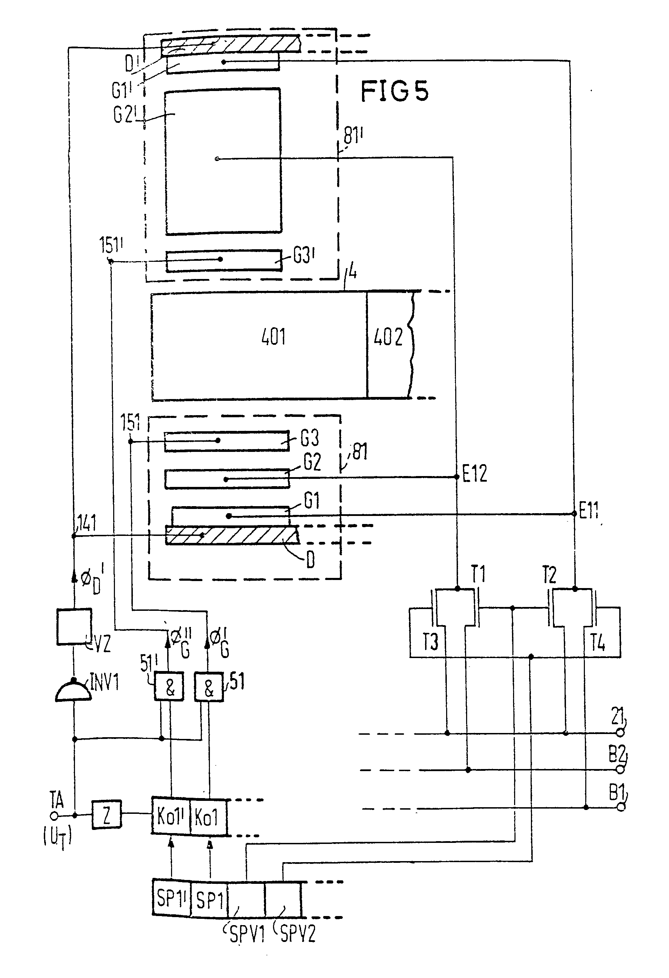

In Figur 5 ist ein anderes Ausführungsbeispiel der Erfindung schematisch dargestellt, bei dem die an der ersten Stufe 401 des Schieberegisters auf verschiedenen Seiten des Transferkanals liegenden Bewertungsschaltungen 81 und 81' mit den bereits anhand der Figuren 1 und 4 beschriebenen Teilen D, G1, G2, und G3 bzw. D', G1', G2' und G3' versehen sind. Die ersten Eingangsgate-Elektroden G1 und G1' sind an einen gemeinsamen Anschluß E11 geführt, die zweiten Eingangsgate-Elektroden G2 und G2' an einen gemeinsamen Anschluß E12. Damit sind beide Bewertungsschaltungen beim Zuführen des Eingangssignals $u_e$ vom Paralleleingang 21 an den Anschluß E12 und bei gleichzeitiger Zuführung von U1 an E11 für einen positiven Bewertungskoeffizienten eingerichtet, während sie beim Zuführen von $u_e$ an E11 und gleichzeitigem Belegen E12 mit der Gleichspannung U2 ein negatives Vorzeichen ergeben.

Die genannten zwei Möglichkeiten der Ansteuerung von E11 und E12 werden mittels zweier weiterer digitaler Speicher SPV1 und SPV2, die wieder als Stufen des bereits anhand von Figur 4 beschriebenen statistischen Schieberegisters ausgebildet sein können, erreicht. Der Ausgang von SPV1 ist mit Gateelektroden zweier Feldeffekttransistoren T1 und T2 beschaltet, der Ausgang von SPV2 mit den Gateelektroden zweier weiterer Feldeffekttransistoren T3 und T4. Die Source-Drain-Strecke von T2 liegt zwischen dem Anschluß 21 und E11, die von T3 zwischen 21 und E12, die von T1 zwischen B2 und E12 und die von T4 zwischen B1 und E11. Speichert man in SPV1 eine "O" und in SPV2 eine "1" ein, so daß der Ausgang von SPV2 spannungsführend ist, der Ausgang von SPV1 dagegen nicht, so sind T3 und T4 leitend, was eine Zuführung von $u_e$ an $E_{12}$ und eine Zuführung von U1 an E11 bedeutet. Damit ist die Schaltung 81 für einen positiven Bewertungskoeffizienten ausgelegt, was auch für die Schaltung 81' gilt. Ist eine "1" in SPV1 eingespeichert, in SPV2 dagegen eine "O", so wird $u_e$ an den Anschluß E11 gelegt und U2 an den Anschluß E12. Damit wird ein negatives Vorzeichen der Bewertungskoeffizienten der Schaltungen 81 und 81' erreicht.

Die Zuführung der für die Transfergateelektroden G3 der Schaltungen 81 und 81' vorgesehenen Taktspannungen $\phi_G'$ und $\phi_G''$ an den Eingängen 151 und 151' wird in der bereits anhand von Figur 4 beschriebenen Weise über UND-Gatter 51 und 51', Komparatoren Ko1 und Ko1', digitale Speicher SP1 und SP1' und einen Zähler Z kontrolliert, wobei der Zähler Z und die ersten Eingänge der UND-Gatter 51 und 51' wieder an einem Anschluß TA liegen, an dem eine Taktspannung $U_T$ anfällt. Von der Spannung $U_T$ wird auch die den entgegengesetzt zum Substrat dotierten Gebiete D und D' über den gemeinsamen Anschluß 141 zugeführte Taktspannung $\phi_D'$ über einen Inverter INV1 und ein Verzögerungsglied VZ abgeleitet.

Wie aus Figur 5 ersichtlich ist, kann man die Fläche von G2' wesentlich größer wählen als die Fläche von G2. Damit wird erreicht, daß der Einlesevorgang, der über die Schaltung 81' abläuft, zur Grobeinstellung des Bewertungskoeffizienten dient, während der Einlesevorgang über die Schaltung 81 eine zusätzliche Feineinstellung ergibt. Dabei stehen die jeweils über 81' und 81 eingelesenen Ladungsmengen im Verhältnis der Flächen von G2' und G2, wobei dieses Verhältnis vorzugsweise einen Wert von 10 oder 100 annehmen kann. Die Anzahl der jeweils eingelesenen Ladungsmengen wird durch die in SP1 und SP1' gespeicherten digitalen Zahlen bestimmt. Aus der Kombination beider Einlesevorgänge ergibt sich eine sehr schnelle Einlesung auch bei solchen Koeffizienten, deren Betrag durch große digitale Zahlenwerte festgelegt ist.

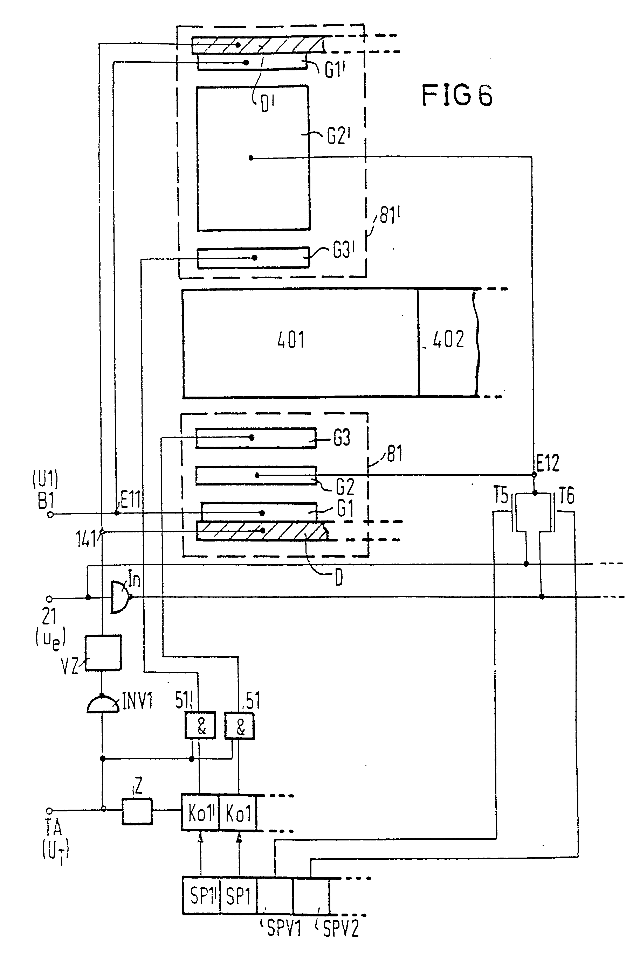

Das in Figur 6 dargestellte Ausführungsbeispiel der Erfindung unterscheidet sich von Figur 5 nur durch eine andere Ansteuerung der gemeinsamen Anschlüsse E11 und E12. Um hierbei die bewertungsschaltungen 81 und 81' für einen positiven Bewertungskoeffizienten auszulegen, was durch Zuführung von $u_e$ an E12 und von U1 an E11 geschieht, wird in SPV1 eine "1" und in SPV2 eine "0" abgespeichert, wobei ein über den Ausgang von SPV1 angesteuerter Schalttransistor T5 öffnet und den Paralleleingang 21 mit dem Anschluß E12 verbindet. Ein negativer Koeffizient wird eingestellt, wenn in SPV1 eine "0" und in SPV2 eine "1" gespeichert wird. In diesem Fall öffnet ein über den Ausgang von SPV2 angesteuerter Schalttransistor T6, dessen Source-Drain-Strecke einerseits über einen Inverter In an 21 und andererseits an E12 geschaltet ist. Damit wird dem Anschluß E12 das invertierte Eingangssignal $u_e$ zugeführt, während E11 mit U1 belegt ist.

In Abweichung von dem bisher beschriebenen Prinzip der digitalen Steuerung der Taktspannungen $\phi_G'$ und $\phi_G''$, die den Transfergateelektroden, z.B. $G_3$ und $G_3'$ von 81 und 81', zugeführt werden, können selbstverständlich stattdessen auch die den entgegengesetzt zum Substrat dotierten Gebieten D und D' augeführten Taktspannungen $\phi_D'$ ditital gesteuert werden. Dabei werden dann die Anschlüsse 151, 151' usw. der Transfergateelektroden der Bewertungsschaltungen 81, 81' usw. direkt an den Anschluß TA geführt, während die dotierten Gebiete D, D' usw. der einzelnen Bewertungsschaltungen voneinander getrennt ausgebildet und mit jeweils eigenen Anschlüssen versehen sind. An diese werden dann individuell zugeordnete Spannungen $\phi_D'$ geführt, die vom Anschluß TA über einen Inverter INV1 und ein Verzögerungsglied VZ sowie über jeweils eine der über die Komparatoren Ko1, Ko1' usw. und Speicher SP1, SP1' kontrollierten UND-Gatter 51, 51' usw. abgeleitet sind. In diesem Fall können dann sämtliche der auf einer Seite des CTD-Transferkanals angeordneten Transfergateelektroden G3 der Bewertungsschaltungen 81, 82 usw, zu einem gemeinsamen Transfergate zusammengefaßt sein. Diesem wird dann eine gemeinsame Taktspannung $\phi_G'$ über einen Anschluß 151 zugeführt.

## Patentansprüche

1. Transversalfilter, bei dem die Stufen eines auf einem dotierten Halbleitersubstrat integrierten, analogen CTD-Schieberegisters (4) mit Paralleleingängen (21, 22, ..., 2n) und diesen vorgeschalteten Bewertungsschaltungen (81, 82, ..., 8n) versehen sind, bei dem die Bewertungsschaltungen jeweils ein entgegengesetzt zu dem Substrat (1) dotiertes Gebiet (D), ein erstes und zweites Eingangsgate (G1, G2) und ein Transfergate (G3) aufweisen, wobei das Transfergate unmittelbar neben dem Transferkanal des CTD-Schieberegisters (4) angeordnet ist, das eine Eingangsgate mit einem Eingangssignal ($u_e$), das andere Eingangsgate mit einer konstanten Gleichspannung (U1, U2), das entgegengesetzt dotierte Gebiet (D) mit einer ersten ($\phi_D'$) und das Transfergate (G3) mit einer zweiten Taktspannung ($\phi_G'$) beschaltet sind, und bei dem das Ausgangssignal ($u_a$) an einem Ausgang (3) des CTD-Schieberegisters abgriefbar ist, dadurch gekennzeichnet, daß Komparatoren (Ko1 ... Kon) vorgesehen sind, deren erste Eingänge mit einem mit Taktimpulsen beaufschlagten Zähler (Z) und deren zweite Eingänge mit digitalen Speichern (SP1 ... SPn) beschaltet sind, und daß die Ausgänge der Komparatoren (Ko1 ... Kon) mit Torschaltungen (51 ... 5n) verbunden sind, die die Bewertungsschaltungen (81, 82 ... 8n) gegen eine der zugeführten Taktspannungen ($\phi_G'$, $\phi_D'$) in Abhängigkeit von den jeweiligen Vergleichsergebnissen swischen dem Zählersignal einerseits und von in die Speicher (SP1 ... SPn) eingegebenen digitalen Signalen andererseits sperren, und daß die Folgefrequenz der Taktspannungen ($\phi_G'$, $\phi_D'$) derart hoch ist, daß unbeeinflußt von der Folgefrequenz der Verschiebetaktspannung ($\phi1$) eine der Amplitude des Eingangssignals ($u_e$) proportionale Ladungsmenge (F) vorgebbar oft von jeder der Bewertungsschaltungen (81, 82 ..., 8n) in das CTD-Schieberegister (4) eingebbar ist.

2. Transversalfilter nach Anspruch 1, dadurch gekennzeichnet, daß eine Bewertungsschaltung (81) dadurch für einen positiven Bewertungskoeffizienten eingerichtet ist, daß das erste Eingangsgate (G1) dem entgegengesetzt dotierten Bereich benachbart und mit einer Gleichspannung (U1) beschaltet ist, die höchstens so groß ist wie das kleinste zu bewertende Eingangssignal ($u_e$), und daß das zweite Eingangsgate (G2) dem Transfergate (G3) benachbart und mit dem Eingangssignal ($u_e$) beschaltet ist.

3. Transversal filter nach Anspruch 1, dadurch gekennzeichnet, daß eine Bewertungsschaltung (8n) dadurch für einen negativen Bewertungskoeffizienten eingerichtet ist, daß das erste Eingangsate dem entgegengesetzt dotierten Gebiet benachbart und mit dem Eingangssignal ($u_e$) beschaltet ist, und daß das zweite Eingangsgate dem Transfergate benachbart und mit einer Gleichspannung (U2) beschaltet ist, die mindestens so groß ist wie das größte zu bewertende Eingangssignal ($u_e$).

4. Transversalfilter nach Anspruch 1, dadurch gekennzeichnet, daß die Bewertungsschaltung dadurch für einen negativen bewertungskoeffizienten eingerichtet ist, daß das erste Eingangsgate dem entgegengesetzt dotierten Gebiet benachbart und mit einer Gleichspannung beschaltet ist, die höchstens so groß ist wie das kleinste zu bewertende Eingangssignal ($u_e$), und daß das zweite Eingangsgate dem Transfergate benachbart und mit dem inversen Eingangssignal ($u_e$) beschaltet ist.

5. Transversalfilter nach dem Anspruch 1 und einem der Ansprüche 2 bis 4, dadurch gekennzeichnet, daß eine oder mehrere Stufen (401) des CTD-Schieberegisters (4) jeweils zusätzlich mit einem zweiten Paralleleingang (21') versehen sind wobei die zu einer Stufe (401) gehörenden Paralleleingänge (21, 21') mit Bewertungsschaltungen (81, 81') versehen sind, die für dasselbe Vorzeichen des Bewertungskoeffizienten eingerichtet sind.

6. Transversalfilter nach den Ansprüchen 1, 2 und einem der Ansprüche 3 oder 4, dadurch gekennzeichnet, daß eine mit einem ersten Paralleleingang (21) und einer Bewertungsschaltung (81) für einen positiven Bewertungskoeffizienten versehene Stufe (401) des analogen CTD-Schieberegisters (4) zusätzlich mit einem zweiten Paralleleingang (21') und einer Bewertungsschaltung (81') für einen negativen Bewertungskoeffizienten versehen ist, und daß eine dieser beiden Bewertungsschaltungen über den ihr zugeordneten Komparatorausgang (Ko1') von einem digitalen Speicher (SP1') gesteuert wird, in den das Signal "Null" eingegeben ist.

7. Transversalfilter nach Anspruch 5 und 6, dadurch gekennzeichnet, daß die beiden Paralleleingänge (21, 21'), die ein und derselben Stufe (401) des CTD-Schieberegisters (4) zugeordnet sind, bezüglich des CTD-Transferkanals so angeordnet sind, daß sie einander gegenüberliegen.

8. Transversalfilter nach Anspruch 7, dadurch gekennzeichnet daß das zweite Eingangsgate (G2') der auf der einen Seite des CTD-Transferkanals liegenden Bewertungsschaltung (81') wesentlich großflächiger ausgebildet ist als das zweite Eingangsgate (G2) der auf der anderen Seite Liegenden Bewertungsschaltung (81).

9. Transversalfilter nach Anspruch 8, dadurch gekennzeichnet, daß ein gemeinsamer Anschluß (E11) für die ersten Eingangsgateelektroden (G1, G1') und ein gemeinsamer Anschluß (E12) für die zweiten Eingangsgateelektroden (G2, G2') der beiden einander gegenüberliegenden Bewertungsschaltungen (81, 81') einer Schieberegisterstufe (401) vorgesehen sind, die mittels Schalttransistoren (T1 bis T4), die über zwei weitere digitale Speicher (SPV1, SPV2) ansteuerbar sind, wahlweise an das Eingangssignal $u_e$, an eine konstante Gleichspannung (U1), die höchstens so groß ist wie das kleinste Eingangssignal ($u_e$) und an eine konstante Gleichspannung (U2), die wenigstens so groß ist wie das größte Eingangssignal ($u_e$), anschaltbar sind.

10 Transversalfilter nach Anspruch 8, dadurch gekennzeichnet, daß ein gemeinsamer Anschluß (E1) für die ersten Eingangsgateelektroden (G1, G1') und ein gemeinsamer Anschluß (E12) für die zweiten Eingangsgateelektroden (G2, G2') der beiden einander gegenüberliegenden Bewertungsschaltungen (81, 81') einer Schieberegisterstufe (401) vorgesehen sind, die mittels Schalttransistoren (T5, T6), die über zwei weitere digitale Speicher (SPV1, SPV2) ansteuerbar sind, wahlweise an das Eingangssignal ($u_e$), an das invertierte Eingangssignal und an eine konstante Gleichspannung (U1), die höchstens so groß ist wie das kleinste Eingangssignal ($u_e$), anschaltbar sind.

11. Transversalfilter nach einem der vorhergehenden Ansprüche, dadurch gekennzeichnet, daß die digitalen Speicher (SP1 ... SPn, SPn' ... SP1') als Stufen eines statischen Schieberegisters au6gebildet sind.

12. Transversalfilter nach einem der vorhergehenden Ansprüche, dadurch gekennzeichnet, daß es als eine auf einem Halbleitersubstrat monolithisch integrierte Halbleiterschaltung ausgebildet ist.

## Claims

1. A transversal filter wherein the stages of an analogue CTD shift register (4) integrated on a doped semiconductor substrate are provided with parallel inputs (21, 22, ... 2n) preceded by evaluating circuits (81, 82, ... 8n), wherein the evaluating circuits each possess an oppositely doped zone (D), a first and second input gate (G1, G2), and a transfer gate (G3), the transfer gate being arranged directly beside the transfer channel of the CTD shift register (4), one input gate being supplied with one input signal ($u_e$), the other input gate supplied with a constant d.c. potential (U1, U2), the oppositely doped zone (D) supplied with a first timing voltage ($\phi_D'$) and the transfer gate (G3) supplied with a second timing voltage ($\phi_G'$), and wherein the output signal ($u_e$) can be tapped from an output (3) of the CTD shift register, characterised in that comparators (Ko1 ... Kon) are provided whose first inputs are connected to a counter (Z) which is supplied with timing pulses and whose second inputs are connected to digital stores (SP1 ... SPn), and that the outputs of the comparators (Ko1 ... Kon) are connected to gate circuits (51 ... 5n) which block the evaluating circuits (81, 82, ... 8n) in respect of one of the supplied timing voltages ($\phi_G'$, $\phi_D'$) in dependence upon the results of the comparison between the counter signal on the one hand and digital signals which have been input into the stores (SP1 ... SPn) on the other hand, and that the level of the repetition frequency of the timing voltages ($\phi_G'$, $\phi_D'$) is such that a quantity of charge which is proportional to the amplitude of the input signal ($u_e$) can be input from each of the evaluating circuits (81, 82, ... 8n) into the CTD shift register (4) with predeterminable frequency regardless of the repetition frequency of the shift clock voltage ($\phi 1$).

2. A transversal filter as claimed in Claim 1, characterised in that an evaluating circuit (81) is set up for a positive evaluation coefficient in that the first input gate (G1) is adjacent to the oppositely doped zone and is connected to a d.c. voltage (U1) whose magnitude is at the most equal to the smallest input signal ($u_e$) which is to be evaluated, and that the second input gate (G2) is adjacent to the transfer gate and is connected to the input signal ($u_e$).

3. A transversal filter as claimed in Claim 1, characterised in that an evaluating circuit (8n) is set up for a negative evaluation coefficient in that the first input gate is adjacent to the oppositely doped zone and is connected to the input signal ($u_e$), and that the second input gate is adjacent to the transfer gate and is connected to a d.c. voltage (U2) which is at least equal in magnitude to the largest input signal ($u_e$) which is to be evaluated.

4. A transversal filter as claimed in Claim 1, characterised in that the evaluating circuit is set up for a negative evaluation coefficient in that the first input gate is adjacent to the oppositely doped zone and is connected to a d.c. voltage which is at the most equal in magnitude to the smallest input signal ($u_e$) which is to be evaluated, and that the second input gate is adjacent to the transfer gate and is connected to the inverse input signal ($u_e$).

5. A transversal filter as claimed in Claim 1 and one of Claims 2 to 4, characterised in that one or more than one stage (401) of the CTD shift register (4) is in each case additionally provided with a second parallel input (21'), where the parallel inputs (21, 21') which belong to a stage (401) are provided with evaluating circuits (81, 81') which are set up for the same sign of the evaluation coefficient.

6. A transversal filter as claimed in Claims 1, 2 and one of Claims 3 or 4, characterised in that a stage (401) of the analogue CTD shift register (4) which is provided with a first parallel input (21) and an evaluation circuit (81) for a positive evaluation coefficient is additionally provided with a second parallel input (21') and an evaluation circuit (81') for a negative evaluation coefficient, and that one of these two evaluation circuits is controlled via the comparator output (Ko1') which it is assigned by a digital store (SP1') into which the "zero" signal is input.

7. A transversal filter as claimed in Claim 5 and Claim 6 characterised in that the two parallel inputs (21, 21') which are assigned to one and the same stage (401) of the CTD shift register (4) are arranged in such a manner relative to the CTD transfer channel, that they lie opposite one another.

8. A transversal filter as claimed in Claim 7, characterised in that the second input gate (G2') of the evaluation circuit (81') located one one side of the CTD transfer channel has a substantially larger surface than the second input gate (G2) of the evaluation circuit (81) arranged on the other side.

9. A transversal filter as claimed in Claim 8, characterised in that a common terminal (E11) is provided for the first input gate electrodes (G1, G1') and a common terminal (E12) is provided for the second input gate electrodes (G2, G2') of the two mutually oppositely arranged evaluation circuits (81, 81') of a shift register stage (401) which, by means of switching transistor (T1 to T4) operated via two further digital stores (SPV1, SPV2) can be selectively connected to the input signal ($u_e$) to a constant d.c. voltage (U1) which at the most is equal to the smallest input signal ($u_e$) and to a constant d.c. voltage (U2) which is at least equal to the largest input signal ($u_e$).

10. A transversal filter as claimed in Claim 8, characterised in that a common terminal (E1) is provided for the first input gate electrodes (G1, G1') and a common terminal (E12) is provided for the second input gate electrodes (G2, G2'), of the two oppositely arranged evaluation circuits (81, 81') of a shift register (401), selectively connected by means of switching transistors (T5, T6) which can be operated via two further digital stores (SPV1, SPV2), to the input signal ($u_e$), to the inverted input signal, and to a constant d.c. voltage (U1) which is at the most equal to the smallest input signal ($u_e$).

11. A transversal filter as claimed on one of the preceding claims, characterised in that the digital stores (SP1 ... SPn, SPn' ... SP1') are designed as stages of a static shift register.

12. A transversal filter as claimed in one of the preceding claims, characterised in that it is designed as a monolithic integrated semiconductor circuit on a semiconductor substrate.

**Revendications**

1. Filtre transversal dans lequel les étages d'un registre à décalage CTD (4), intégrés sur le substrat semiconducteur dopé, est pourvu d'entrées parallèles (21, 22 ... 2n) et de circuits de pondération (81, 82 ... 8n) montés en amont de ces dernières, dans lequel des circuits de pondération comportent chacun une plage (D) dopée en sens opposé au substrat (1), une première et seconde portes d'entrée (G1, G2) et une porte de transfert (G3), la porte de transfert étant disposée dans le voisinage immédiat du canal de transfert du registre CTD, la première porte d'entrée recevant un signal d'entrée ($u_e$), la seconde porte d'entrée recevant une tension continue constante (U1, U2), la plage (D) dopée en sens opposé recevant une première tension d'horloge ($\phi_D'$) et la porte de transfert (G3) recevant une seconde tension d'horloge ($\phi_G'$) alors que le signal de sortie ($u_a$) est susceptible d'être prélevé au niveau de la sortie (3) du registre à décalage CTD, caractérisé par le fait qu'il est prévu des comparateurs (Ko1 ... Kon) dont les premières entrées sont reliées à un compteur (Z) recevant des impulsions d'horloge et dont les secondes horloges d'entrée sont reliées à des mémoires numériques (SP1 ... SP2), que les sorties des comparateurs (Ko1 ... Kon) sont reliées à des circuits de porte (51 ... 5n) qui bloquent les circuits de pondération (81, 82 ... 8n) contre l'une des tensions d'horloge appliquées ($\phi_G'$, $\phi_D'$), en fonction des résultats de comparaison entre d'une part le signal du compteur et d'autre part les signaux numériques introduits dans les mémoires (SP1 ... SPn), et que la fréquence de répétition des tensions d'horloge ($\phi'_G$, $\phi'_D$) este élevée au point que sans être influencée par la fréquence de répétition de la tension de la cadence de décalage, une quantité de charge (F) qui est proportionnelle à l'amplitude du signal d'entrée ($u_e$) est susceptible d'être introduite un nombre prédéterminé de fois de chaque circuit de pondération (81, 82 ... 8n) dans le registre à décalage CTD (4).

2. Filtre transversal selon la revendication 1, caractérisé par le fait qu'un circuit de pondération (81) est agencé pour un coefficient de pondération positif grâce au fait que la première porte d'entrée (G1) est voisine de la plage dopée en sens opposé et reçoit une tension continue (U1) dont la valeur est au maximum égale au signal d'entrée ($u_e$) le plus petit à pondérer, et que la seconde porte d'entrée (G2) est voisine de la porte de transfert (G3) et reçoit le signal d'entrée ($u_e$).

3. Filtre transversal selon la revendication 1, caractérisé par le fait qu'un circuit de pondération (8n) est agencé pour un coefficient de pondération négatif grâce au fait que la première porte d'entrée est voisine de la plage dopée en sens opposé et reçoit le signal d'entrée ($u_e$) et que la seconde porte d'entrée est voisine de la porte de transfert et reçoit une tension continue (U2) qui est au moins aussi grande que le signal d'entrée ($u_e$) le plus grand qui est à pondérer.

4. Filtre transversal selon la revendication 1, caractérisé par le fait que le circuit de pondération est agencé pour un coefficient de pondération négatif grâce au fait que la première porte d'entrée est voisine de la plage dopée en sens opposé et reçoit une tension continue qui est au moins aussi grande que le signal d'entrée ($u_e$) le plus faible à pondérer, et que la seconde porte d'entrée est voisine de la porte de transfert et reçoit le signal d'entrée inverse ($u_e$).

5. Filtre transversal selon la revendication 1 et l'une des revendications 2 à 4, caractérisé par le fait qu'un ou plusieurs étages (401) du registre à décalage CTD (4) est pourvu en plus d'une seconde entrée parallèle (21'), les entrées parallèles (21, 21') appartenant à un étage (401) étant pourvues de circuits de pondération (81, 81') qui sont agencés pour le même signe du coefficient de pondération.

6. Filtre transversal selon les revendications 1, 2 et l'une des revendications 3 ou 4, caractérisé par le fait qu'un étage (401) du registre à décalage analogique CTD (4), pourvu d'une première entrée parallèle (21) et d'un circuit de pondération (81) pour un coefficient de pondération positif, est pourvu, en plus, d'une seconde entrée parallèle (21') et d'un circuit de pondération (81') pour un coefficient de pondération négatif, et que l'un de ces deux circuits de pondération est commandé, par l'intermédiaire de la sortie de comparateur (Ko1') qui lui est associé, par une mémoire numérique (SP1') dans laquelle est introduit le signal "Nul".

7. Filtre transversal selon les revendications 5 et 6, caractérisé par le fait que les deux entrées parallèles (21, 21') qui sont associées à un seul et même étage (401) du registre à décalage CTD (4) sont disposées, par rapport au canal de transfert CTD de manière à ce qu'elles soient situées l'une en face de l'autre.

8. Filtre transversal selon la revendication 7, caractérisé par le fait que la seconde porte d'entrée (G2') du circuit de pondération (81') qui se situe sur un côté du canal de transfert CTD a une surface notablement supérieure à celle de la seconde porte d'entrée (G2) du circuit de pondération qui se situe sur l'autre côté du canal de transfert CTD.

9. Filtre transversal selon la revendication 8, caractérisé par le fait qu'il est prévu une borne de raccordement commune (E11) pour les premières électrodes d'entrée (G1, G1') et une borne de raccordement commune (E12) pour les secondes électrodes d'entrée (G2, G2') des deux circuits de pondération (81, 81') opposés d'un même étage du registre à décalage (401) à l'aide de transistors de commutation (T1 à T4) susceptibles d'être commandés par l'intermédiaire de deux autres mémoires digitales (SPV1, SPV2) qui peuvent être reliées au choix au signal d'entrée ($u_e$) à une tension continue constante (U1) qui est au plus égale au signal d'entrée le plus petit ($u_e$) et à une tension constante continue (U2) qui est au moins aussi grande que le signal d'entrée le plus grand ($u_e$).

10. Filtre transversal selon la revendication 8, caractérisé par le fait qu'il est prévu une borne de raccordement commune (E1) pour les premières électrodes d'entrée (G1, G1') et une borne de raccordement commune (E12) pour les secondes électrodes d'entrée (G2, G2') des deux circuits de pondération opposés (81, 81') d'un étage (401) du registre à décalage, qui, par l'intermédiaire de transistors (T5, T6) susceptibles d'être commandés par deux autres mémoires numériques (SPV1, SPV2), sont susceptibles d'être reliés au choix au signal d'entrée ($u_e$), au signal d'entrée inversé et à une tension continue constante (U1) qui est au maximum aussi grande que le signal d'entrée plus petit ($U_e$).

11. Filtre transversal selon l'une des revendications précédentes, caractérisé par le fait que les mémoires numériques (SP1 ... SPn ... SP1') sont réalisées sous la forme d'étages d'un registre à décalage statique.

12. Filtre transversal selon l'une des revendications précédentes, caractérisé par le fait qu'il est réalisé sous la forme d'un circuit à semiconducteurs monolithique intégré sur un substrat semiconducteur.

# FIG 1

0 004 870

# FIG 2

II — II

# FIG 3

FIG 4

0 004 870

FIG 5

FIG 6